# EUROPEAN PATENT APPLICATION

(11) **EP 4 787 218 A1**
(43) Date of publication of application: **05.08.2026**
(21) Application number: 24888428.0
(22) Date of filing: 30.09.2024
(51) Int. Cl.: G06F 30/20, A43D 1/02, G06F 30/12

(54) **DESIGN ASSISTANCE DEVICE, DESIGN ASSISTANCE METHOD, AND DESIGN ASSISTANCE PROGRAM**

(30) Priority: 09.11.2023 JP 2023191501
(71) Applicant: ASICS Corporation, Kobe-shi, Hyogo 650-0021 (JP)
(72) Inventor: HATANO, Genki, Kobe-shi, Hyogo 650-0021 (JP); KOZUKA, Yuya, Kobe-shi, Hyogo 650-0021 (JP)
(74) Representative: TBK
(86) International application number: PCT/JP2024/034880
(87) International publication number: WO 2025/100129

(57) **Abstract**

There are provided a design assistance apparatus, a design assistance method and a design assistance program, which are capable of designing, based on evaluation by a user, a product having a property that satisfies the user. A design assistance apparatus (1) is an apparatus for designing a product suited to a preference of a user. The design assistance apparatus (1) includes: a storage unit that stores in advance a first criterion that allows selection from a plurality of levels of a property of the product; an input unit that receives an evaluation value obtained based on evaluation by the user after the user uses the product manufactured in accordance with a level selected by the user from the first criterion; processing circuitry that determines, based on the evaluation value and the first criterion, a second criterion for the property of the product that matches the evaluation by the user; and an output unit that outputs the second criterion determined by the processing circuitry.

## Description

### TECHNICAL FIELD

The present disclosure relates to a design assistance apparatus, a design assistance method and a design assistance program.

### BACKGROUND

Various attempts are made to design a product suited to a preference of a user. For example, in Japanese National Patent Publication No. 2022-550301 (PTL 1), a custom-made sole tailored to a foot shape is designed using a personalized parameter value, in order to achieve an improved fit of a shoe.

### CITATION LIST

### PATENT LITERATURE

PTL 1: Japanese National Patent Publication No. 2022-550301

### SUMMARY

### TECHNICAL PROBLEM

However, when a product suited to a preference of a user is designed, user criteria for properties of the product vary significantly from person to person. Therefore, when there is a difference between user criteria for properties of a product and criteria determined in advance by a manufacturer, it is difficult to design the product having the properties that satisfy the user.

The present disclosure has been made to solve the above-described problem and an object thereof is to provide a design assistance apparatus, a design assistance method and a design assistance program, which are capable of designing a product having a property that satisfies a user.

### SOLUTION TO PROBLEM

A design assistance apparatus according to an aspect of the present disclosure is a design assistance apparatus for designing a product suited to a preference of a user. The design assistance apparatus includes: a storage unit that stores in advance a first criterion that allows selection from a plurality of levels of a property of the product; an input unit that receives an evaluation value obtained based on evaluation by the user after the user uses the product manufactured in accordance with a level selected by the user from the first criterion; processing circuitry that determines, based on the evaluation value and the first criterion, a second criterion for the property of the product that matches the evaluation by the user; and an output unit that outputs the second criterion determined by the processing circuitry.

A design assistance method according to an aspect of the present disclosure is a design assistance method for designing a product suited to a preference of a user. The design assistance method includes: reading, from a storage unit, a first criterion that allows selection from a plurality of levels of a property of the product; receiving an evaluation value obtained based on evaluation by the user after the user uses the product manufactured in accordance with a level selected by the user from the first criterion; determining, based on the evaluation value and the first criterion, a second criterion for the property of the product that matches the evaluation by the user; and outputting the determined second criterion.

A design assistance program according to an aspect of the present disclosure is a design assistance program performed by a computer for designing a product suited to a preference of a user. The design assistance program causes the computer to implement: a reading unit that reads, from a storage unit, a first criterion that allows selection from a plurality of levels of a property of the product; an input unit that receives an evaluation value obtained based on evaluation by the user after the user uses the product manufactured in accordance with a level selected by the user from the first criterion; processing circuitry that determines, based on the evaluation value and the first criterion, a second criterion for the property of the product that matches the evaluation by the user; and an output unit that outputs the determined second criterion.

### ADVANTAGEOUS EFFECTS OF INVENTION

According to the present disclosure, the second criterion for the property of the product that matches the evaluation by the user can be determined based on the evaluation value and the first criterion, and the product having the property that satisfies the user can be designed based on the second criterion.

### BRIEF DESCRIPTION OF THE DRAWINGS

Fig. 1 is a schematic diagram showing a configuration of a system including a design assistance apparatus according to an embodiment.
Fig. 2 is a block diagram showing a configuration of the design assistance apparatus according to the embodiment.
Fig. 3 is a diagram for describing properties of a product when the product is a footwear.
Fig. 4 is a flowchart showing a design process and a feedback process performed by the design assistance apparatus according to the embodiment.
Fig. 5 is a schematic diagram showing the design process and the feedback process in the design assistance apparatus according to the embodiment.
Fig. 6 is another schematic diagram showing the design process and the feedback process in the design assistance apparatus according to the embodiment.
Fig. 7 is still another schematic diagram showing the design process and the feedback process in the design assistance apparatus according to the embodiment.
Fig. 8 is a schematic diagram showing modification of a user criterion based on use information and user information.
Fig. 9 is a schematic diagram showing modification of the user criterion based on a safety criterion.
Fig. 10 is a schematic diagram showing the user criterion generated in accordance with a purpose of use.
Fig. 11 is a schematic diagram showing the user criterion for each portion of the footwear.
Fig. 12 is a schematic diagram showing the user criterion for each portion of the footwear generated in accordance with a purpose of use.

### DETAILED DESCRIPTION

Embodiments of a design assistance apparatus and a design assistance method will be described below with reference to the drawings. In the following description, the same components will be denoted by the same reference characters. Their names and functions are also the same. Therefore, detailed description about them will not be repeated. In the following description, an example of design assistance of a footwear, which is one example of a wearable article worn by a user, in the design assistance apparatus and the design assistance method will be described. However, an article to be designed is not limited to the footwear, but may be a product having a user's preferred property that can be selected by the user, and the present disclosure is also applicable to design assistance of, for example, clothing, gloves, helmets, sports equipment, and the like. Further, designing a product having a property that satisfies a user in the design assistance apparatus and the design assistance method according to the present disclosure includes not only designing the shape of the product but also proposing an existing product corresponding to the shape to be designed.

### [Configuration of Footwear Production System]

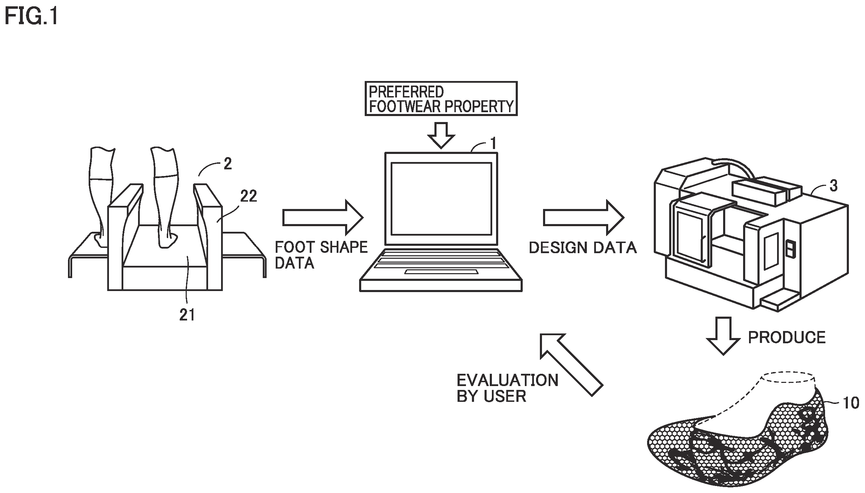

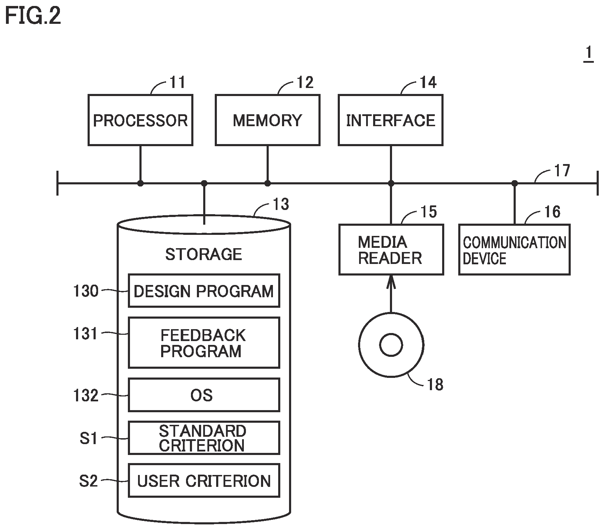

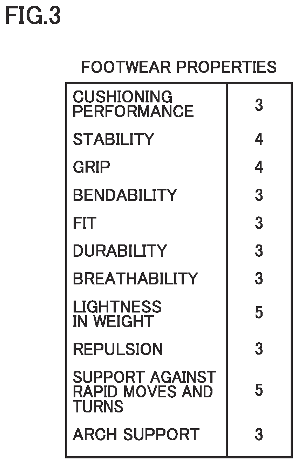

Fig. 1 is a schematic diagram showing a configuration of a system including a design assistance apparatus 1 according to an embodiment. Fig. 2 is a block diagram showing a configuration of the design assistance apparatus 1 according to the embodiment. Fig. 3 is a diagram for describing properties of a product when the product is a footwear. In a store such as a shoe store, an event venue and the like, a custom-made footwear 10 tailored to the individual foot shape is produced. The footwear 10 is designed and produced in consideration of user's preferred footwear properties (e.g., functional properties such as fit), in addition to foot shape data.

Specifically, regarding a user's preferred fit, a user selects a preferred level from five levels: loose, slightly loose, average, slightly tight, and tight, whereby the design assistance apparatus 1 can design the footwear 10 suited to a preference (evaluation) of the user. Not only fit but also the footwear properties such as cushioning performance, stability and grip can, for example, be selected as the preference of the user toward the footwear 10. The design assistance apparatus 1 is an apparatus capable of designing the footwear 10 adjusted to the properties requested for the footwear 10 by the user, not simply designing the footwear 10 in accordance with the foot shape data.

As shown in Fig. 1, a footwear production system including the design assistance apparatus 1 includes the design assistance apparatus 1, a measuring apparatus 2 and a 3D printer 3. The apparatus for producing the footwear 10 is not limited to the 3D printer 3, but may be an apparatus such as an NC machine tool, for example. Further, in the embodiment, an example of using the design assistance apparatus 1 to generate design data for producing the footwear 10 is described. However, the technique of the present disclosure may be applied to a design apparatus for producing the custom-made footwear 10 to cause the design apparatus to generate design data for producing the footwear 10.

The measuring apparatus 2 is, for example, a three-dimensional foot shape scanner with laser measurement, and includes a top plate 21 and a laser measuring unit 22 disposed to sandwich the top plate. When the user puts his/her foot on the top plate 21 in a standing posture, a load is applied from the foot to the top plate 21 due to the body weight of the user. That is, the foot of the user is under the load. In a state where the foot of the user is under the load, the measuring apparatus 2 measures the shape of the foot with the laser measuring unit 22, while moving from the toe to the heel of the foot. The measuring apparatus 2 outputs, to the design assistance apparatus 1, the foot shape data including the foot shape data of the user obtained by the laser measuring unit 22. The foot shape data may include at least the foot shape data obtained by the measuring apparatus 2, and may include other data (e.g., personal data of the user such as gender or age).

The design assistance apparatus 1 obtains the foot shape data from the measuring apparatus 2 and generates, based on the foot shape data and the user's preferred footwear properties, design data for producing the footwear 10. In the design assistance apparatus 1, the levels of each of the footwear properties to be selected by the user are stored in advance in a storage 13 (storage unit) as a standard criterion S1 (first criterion). However, the level determined in the standard criterion S1 does not necessarily match the level evaluated subjectively by the user. When there is a difference between the level determined in the standard criterion S1 and the level evaluated subjectively by the user, it is difficult to design and produce the footwear 10 having the properties that satisfy the user. For example, assuming that the user's preferred fit of the footwear 10 is tight, the footwear 10 is designed with a design value, which is 90% of a reference design value, based on the standard criterion S1, and the user actually wears the produced footwear 10 to perform evaluation. Then, the user may feel slightly loose. Thus, the design assistance apparatus 1 provides a feedback about the subjective evaluation by the user, thereby determining user criterion S2 (second criterion) that matches the user's subjective opinion. A specific method for determining the user criterion S2 will be described below.

The design assistance apparatus 1 outputs the generated design data about the footwear 10 to the 3D printer 3 or the like that produces the footwear 10. In this way, in the footwear production system, the design assistance apparatus 1 generates the design data about the footwear 10 based on the foot shape data of the user obtained by the measuring apparatus 2 and the received user's preferred footwear properties, and the 3D printer 3 produces the footwear 10 based on the design data. The footwear production system can produce the footwear 10 having the properties that satisfy the user, based on the design data about the footwear 10 generated by the design assistance apparatus 1.

Although production of the footwear 10 using the footwear production system including the design assistance apparatus 1, the measuring apparatus 2 and the 3D printer 3 is described in the present disclosure, the configuration of the apparatus is not limited thereto. The configuration of the apparatus may be a footwear production apparatus in which the design assistance apparatus 1, the measuring apparatus 2 and the 3D printer 3 are integrated, or may be a footwear production apparatus in which the measuring apparatus 2 and the 3D printer 3 are integrated. Furthermore, although a configuration in which the 3D printer 3 or the like produces the entire footwear 10 is described in the present disclosure, the 3D printer 3 or the like may produce a part of the footwear. That is, there may be a pre-made footwear, and parts to be combined with the pre-made footwear may be produced by the above-described 3D printer 3 or the like in order to produce a custom-made footwear. Further, in a footwear production system that produces a custom-made footwear, a plurality of pre-made parts may be selected based on information such as the individual foot shape and these parts may be combined to produce the footwear.

### [Configuration of Design Assistance Apparatus]

As shown in Fig. 2, the design assistance apparatus 1 includes a processor 11, a memory 12, the storage 13, an interface 14, a media reader 15, and a communication device 16. These components are connected to each other via a processor bus 17.

The processor 11 is an example of "processing circuitry". The processor 11 is a computer that reads programs (e.g., a design program 130, a feedback program 131 and an operating system (OS) 132) stored in the storage 13, deploys the read programs onto the memory 12, and executes the programs. The processor 11 is implemented, for example, by a central processing unit (CPU), a field programmable gate array (FPGA), a graphics processing unit (GPU), a multi-processing unit (MPU), or the like. The processor 11 may be implemented by processing circuitry.

The memory 12 is implemented by a volatile memory such as a dynamic random access Memory (DRAM) or a static random access memory (SRAM), a nonvolatile memory such as a read only memory (ROM) or a flash memory, or the like.

The storage 13 is an example of "storage unit". The storage 13 is implemented, for example, by a nonvolatile storage device such as a hard disk drive (HDD) or a solid state drive (SSD). The storage 13 stores data such as standard criterion S1 and user criterion S2, in addition to the programs such as the design program 130, the feedback program 131 and the OS 132.

The design program 130 is a program for performing a process for designing the footwear 10 based on the foot shape data and the user's preferred footwear properties.

The feedback program 131 is a design assistance program for performing a process for providing a feedback about user's evaluation of the predetermined standard criterion S1, thereby determining the user criterion S2 that matches the user's subjective opinion.

In the standard criterion S1, design values are stored in advance for the respective levels of each of the footwear properties that can be selected by the user. For example, regarding the fit, a design value for loose that is 110% of a reference design value, a design value for slightly loose that is 105% of the reference design value, a design value for average that is 100% of the reference design value, a design value for slightly tight that is 95% of the reference design value, and a design value for tight that is 90% of the reference design value are stored in the standard criterion S1.

The user criterion S2 is a criterion for a footwear property determined based on subjective evaluation by the user.

The interface 14 is an example of "input unit" or "output unit". The interface 14 receives an input by the user of the design assistance apparatus 1, and is implemented by a keyboard, a mouse, a touch device and the like.

The media reader 15 receives a storage medium such as a removable disk 18 and obtains data stored in the removable disk 18. The storage medium such as the removable disk 18 may store the programs such as the design program 130 and the feedback program 131.

The communication device 16 is an example of "input unit" or "output unit". The communication device 16 transmits and receives data to and from other devices through wired or wireless communication. For example, the communication device 16 communicates with the measuring apparatus 2, thereby receiving, from the measuring apparatus 2, the foot shape data obtained by the measuring apparatus 2. The communication device 16 communicates with the 3D printer 3, thereby outputting, to the 3D printer 3, the design data about the footwear 10 used to produce the footwear 10. Further, using the communication device 16, the design program 130 and the feedback program 131 may be downloaded into the storage 13.

The design assistance apparatus 1 is not limited to using the communication device 16 to receive the foot shape data from the measuring apparatus 2. For example, the design assistance apparatus 1 may use the interface 14 to receive the foot shape data inputted by the user. Alternatively, the design assistance apparatus 1 may use the media reader 15 to read the foot shape data stored in the removable disk 18.

### [Footwear Properties]

The footwear properties selected by the user will be described with reference to Fig. 3. The footwear properties include the functional properties such as cushioning performance, stability, grip, bendability, durability, breathability, lightness in weight, repulsion, support against rapid moves and turns, and arch support, in addition to fit. First, of the properties included in the footwear properties, the cushioning performance indicates the shock absorbency of the footwear 10 when the footwear 10 hits the ground. The cushioning performance is, for example, indicated by five levels of any impact based on the sensation of the user when the user's foot wearing the footwear 10 hits the ground, and design values are set in advance for the respective levels.

Of the properties included in the footwear properties, the stability indicates the performance of the footwear 10 such as any horizontal displacement relative to the ground surface when the footwear 10 landed thereupon or any lean on the frontal plane. The stability is, for example, indicated by five levels of any horizontal displacement or any lean on the frontal plane based on the sensation of the user when the user's foot wearing the footwear 10 hits the ground, and design values are set in advance for the respective levels.

Of the properties included in the footwear properties, the grip indicates the amount of friction between the footwear 10 worn by the user in motion and the ground surface on which the footwear 10 landed or the amount of friction between the inside of the footwear 10 and the user's foot. The grip is, for example, indicated by five levels of any friction between the footwear 10 worn by the user in motion and the ground surface on which the footwear 10 landed, and design values are set in advance for the respective levels.

Of the properties included in the footwear properties, the bendability indicates how easily the footwear 10 worn by the user is bendable when the user is in motion. The bendability is, for example, indicated by five levels of how easily the footwear 10 worn by the user is bendable based on the sensation of the user in motion wearing the footwear 10, and design values are set in advance for the respective levels.

Of the properties included in the footwear properties, the durability indicates how long the footwear 10 is used or how many times the footwear 10 is used. The durability is, for example, indicated by five levels of the use period or the number of times of uses expected when the user wears and uses the footwear 10, and design values are set in advance for the respective levels.

Of the properties included in the footwear properties, the breathability indicates the amount of air passing through the footwear 10. The breathability is, for example, indicated by five levels of how easily air is allowed to pass through the footwear 10 based on the sensation of the user wearing the footwear 10, and design values are set in advance for the respective levels.

Of the properties included in the footwear properties, the lightness in weight indicates the weight of the footwear 10. The lightness in weight is, for example, indicated by five levels of the weight of the footwear 10 based on the sensation of the user wearing the footwear 10, and design values are set in advance for the respective levels.

Of the properties included in the footwear properties, the repulsion indicates the magnitude of a force that pushes back the footwear 10 when hitting the ground. The repulsion is, for example, indicated by five levels of the magnitude of a force that pushes back the footwear 10 when hitting the ground based on the sensation of the user wearing the footwear 10, and design values are set in advance for the respective levels.

Of the properties included in the footwear properties, the support against rapid moves and turns indicates the degree of stability when the user wearing the footwear 10 makes a turn to right or left. The support against rapid moves and turns is, for example, indicated by five levels of the degree of stability when the user wearing the footwear 10 makes a turn to right or left based on the sensation of the user wearing the footwear 10, and design values are set in advance for the respective levels.

Of the properties included in the footwear properties, the arch support indicates the sensation of support felt by the user for his/her foot arch when wearing the footwear 10. The arch support is indicated, for example, by five levels of the sensation of support felt by the user for his/her foot arch when wearing the footwear 10, and design values are set in advance for the respective levels.

When the custom-made footwear 10 is designed using the design assistance apparatus 1, one level is selected from the five levels of the user's preferred footwear property as shown in Fig. 3, and is inputted to the design assistance apparatus 1. The design assistance apparatus 1 first designs the standard footwear 10 in accordance with the foot shape data, and modifies the design of the footwear 10 with the design value set for the selected level of the footwear property in order to satisfy the user preference, and generates the design data. Of course, the design assistance apparatus 1 may generate the design data from the foot shape data in consideration of the user preference, without temporarily designing the standard footwear 10.

### [Feedback about Evaluation by User]

The design values set in advance for the levels of each of the footwear properties are determined as the standard criterion S1 by a manufacturer. Therefore, the level determined in the standard criterion S1 does not necessarily match the user criterion for the footwear property, and the level evaluated subjectively by the user based on the user criterion may deviate from the level determined in the standard criterion S1. When there is a difference between the standard criterion S1 and the user criterion as described above, it is impossible to design and produce the footwear 10 having the properties that satisfy the user, in spite of selecting the level of each of the user's preferred footwear properties as shown in Fig. 3.

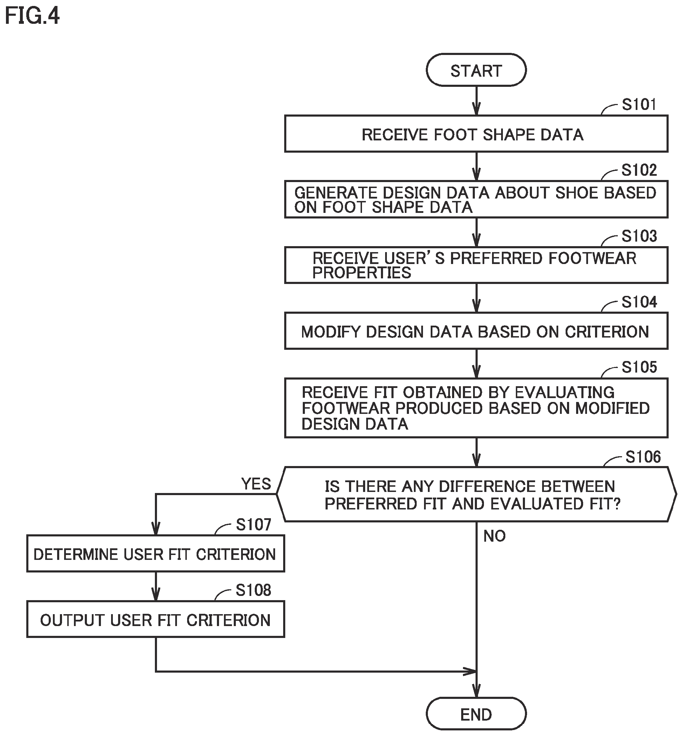

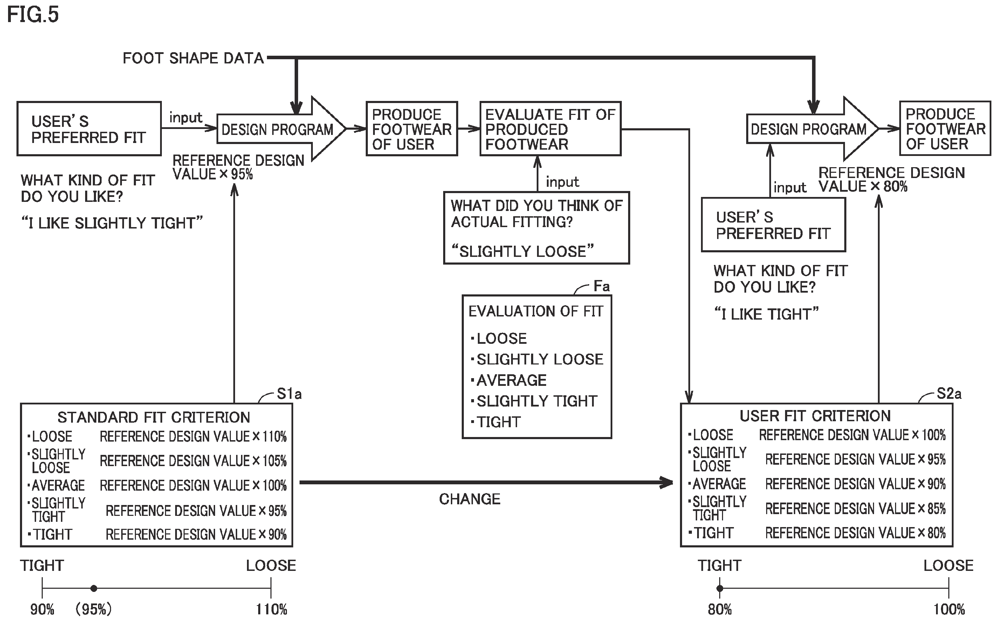

Thus, the design assistance apparatus 1 performs a feedback process for providing a feedback about the subjective evaluation by the user, thereby determining the user criterion S2 (second criterion) that matches the user's subjective opinion (recognition). Fig. 4 is a flowchart showing a design process and a feedback process performed by the design assistance apparatus 1 according to the embodiment. Fig. 5 is a schematic diagram showing the design process and the feedback process in the design assistance apparatus 1 according to the embodiment. The design process is implemented by causing the processor 11 of the design assistance apparatus 1 to perform the design program 130, and the feedback process is implemented by causing the processor 11 of the design assistance apparatus 1 to perform the feedback program 131.

As shown in Fig. 4, the design assistance apparatus 1 receives the foot shape data obtained by the measuring apparatus 2 (step S101). The design assistance apparatus 1 generates the design data about the footwear 10 based on the foot shape data received in step S101 (step S102). Here, the generated design data about the footwear 10 is design data having standard footwear properties in accordance with the foot shape data, and is design data about the footwear 10 generated to correspond to the shape of the foot by using a known method.

The design assistance apparatus 1 further receives footwear properties (e.g., properties shown in Fig. 3) desired by the user (step S103). The footwear properties may, for example, include at least one of cushioning performance, stability, grip, bendability, fit, durability, breathability, lightness in weight, repulsion, support against rapid moves and turns, arch support, and the like. The properties included in the footwear properties described in the present disclosure are provided by way of example and are not intended to be limiting.

Next, the design assistance apparatus 1 modifies the design data generated in step S102 based on the footwear properties received in step S103 (step S104). The design assistance apparatus 1 modifies the design data using the design values for the levels determined in the standard criterion S1. In the following process, for ease of explanation, a feedback process for providing a feedback about subjective evaluation of fit by the user, thereby determining the user criterion S2 that matches the user's subjective opinion will be described.

The design assistance apparatus 1 receives evaluation by the user after the user uses the footwear 10 produced based on the design data modified by the design assistance apparatus 1. This will be specifically described with reference to the schematic diagram shown in Fig. 5. Before producing the footwear 10, the design assistance apparatus 1 receives a user's preferred fit based on the user's answer "I like slightly tight" to the question "What kind of fit do you like?". Based on a standard fit criterion S1a (one criterion about the fit included in the standard criterion S1) stored in the storage 13, the design assistance apparatus 1 modifies, with 95% of the reference design value, the design data about the footwear 10 generated based on the foot shape data. The 3D printer 3 produces the footwear 10 based on the modified design data. The numerical values in the standard fit criterion S1a in the present disclosure are provided by way of example and are not intended to be limiting.

The design assistance apparatus 1 asks the user who used the produced footwear 10 the question "What did you think of actual fitting?" to cause the user to again evaluate the fit of the footwear 10, and receives the answer "slightly loose" from the user, for example. That is, the design assistance apparatus 1 receives an evaluation value for the fit obtained based on the user's evaluation "slightly loose" (step S105). The design assistance apparatus 1 may receive the evaluation value for the fit obtained based on the user's evaluation through speech recognition processing using a microphone and a speaker, or may receive the evaluation value for the fit inputted by the user or a shop assistant with an input device in accordance with characters represented on a display.

The design assistance apparatus 1 determines whether there is a difference between the preferred fit and the evaluated fit (step S106). That is, the design assistance apparatus 1 determines whether the fit of the footwear 10 produced based on the standard fit criterion S1a deviates from the fit evaluated by the user. In the example shown in Fig. 5, the user who used the footwear 10 produced to be "slightly tight" based on the standard fit criterion S1a performs evaluation at the same level (evaluation of the fit Fa) as the standard fit criterion S1a and evaluates the fit of the footwear 10 as being "slightly loose". Therefore, without tightening more strongly than the standard fit criterion S1a, the user does not evaluate the fit of the footwear 10 as being "slightly tight".

Thus, when designing the footwear 10 having the properties that satisfy the user, it is necessary to determine a user fit criterion S2a (one criterion included in user criterion S2) based on subjective evaluation by the user, in order to understand a difference between the preference recognized by the user and the actual preference. Returning to Fig. 4, when there is a difference between the preferred fit selected from the standard fit criterion S1a and the actually evaluated fit (YES in step S106), the design assistance apparatus 1 determines the user fit criterion S2a (step S107).

Specifically, as a method for determining the user fit criterion S2a, the fit criterion S2a is determined such that the level in the evaluation value obtained based on evaluation by the user matches the level in the standard fit criterion S1a. In the example shown in Fig. 5, the design value for "slightly tight" selected from the standard fit criterion S1a as the preference recognized by the user is 95% of the reference design value, whereas the evaluation of the fit Fa obtained based on evaluation by the user actually wearing the footwear 10 is "slightly loose" and is 105% of the reference design value. Since there is a difference of -10% in terms of the design value between the preference recognized by the user and the actual evaluation, the design assistance apparatus 1 shifts the design values for the respective levels in the standard fit criterion S1a by -10% and determines the user fit criterion S2a. The design assistance apparatus 1 outputs the determined user fit criterion S2a to the storage 13 (step S108) and stores the determined user fit criterion S2a. The design assistance apparatus 1 may output the determined user fit criterion S2a to another device such as a server. The numerical values in the user fit criterion S2a in the present disclosure are provided by way of example and are not intended to be limiting.

When the design assistance apparatus 1 designs a new footwear 10 having a fit desired by the user, the design assistance apparatus 1 designs the footwear 10 by using the user fit criterion S2a, not the standard fit criterion S1a. Specifically, when the design assistance apparatus 1 newly designs the footwear 10, the design assistance apparatus 1 receives the user's preferred fit based on the user's answer "I like tight" to the question "What kind of fit do you like?" as shown in Fig. 5. Based on the user fit criterion S2a stored in the storage 13, the design assistance apparatus 1 modifies, with 80% of the reference design value, the design data about the footwear 10 generated based on the foot shape data. As a result, the design assistance apparatus 1 can design, based on the user fit criterion S2a that matches the user's recognition, the footwear 10 having the properties that satisfy the user.

Fig. 5 shows the case in which the design assistance apparatus 1 performs the feedback process on the evaluation by the user actually wearing the footwear 10 designed based on the standard fit criterion S1a, and thereafter, designs the new footwear 10 having the fit desired by the user. However, the feedback process is not limited thereto. For example, the design assistance apparatus 1 may design a temporary footwear based on the standard fit criterion S1a before finally providing the footwear 10, and perform the feedback process on evaluation by the user wearing the temporary footwear, and thereafter, may use the user criterion S2 to design the footwear 10 to be finally provided. Furthermore, when the design assistance apparatus 1 newly receives an evaluation value obtained based on user's evaluation of the footwear 10 produced based on the user criterion S2, the design assistance apparatus 1 may update the user criterion S2 based on the newly received evaluation value. As a result, the design assistance apparatus 1 can obtain the user criterion S2 suited to the latest user preference.

Further, in Fig. 5, the user selects the user's preferred level from the five levels: loose, slightly loose, average, slightly tight, and tight. However, the present disclosure is not limited thereto. For example, the user may use a scale bar shown in Fig. 5 to freely select the user's preferred level from the levels ranging from loose to tight. As a result, the design assistance apparatus 1 can design the footwear 10 suited to the user preference more specifically.

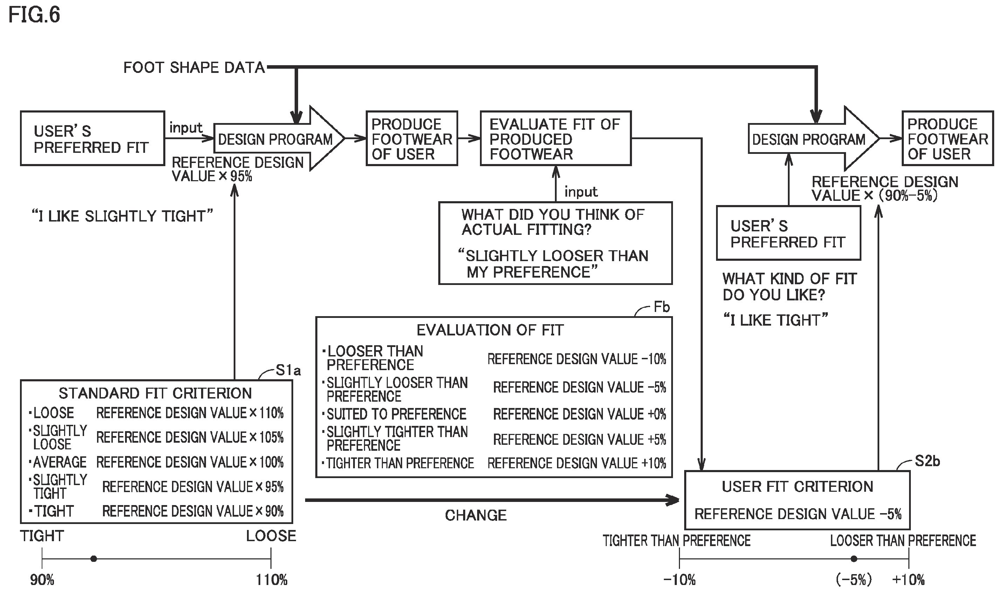

Furthermore, in Fig. 5, the method by which the user again evaluates, in the five levels: loose, slightly loose, average, slightly tight, and tight, the footwear 10 designed based on the standard fit criterion S1a, and determines the user fit criterion S2a is described. However, the feedback process is not limited to this method. Fig. 6 is another schematic diagram showing the design process and the feedback process in the design assistance apparatus 1 according to the embodiment. In the schematic diagram shown in Fig. 6, the same components as those in the schematic diagram shown in Fig. 5 are denoted by the same reference characters and detailed description will not be repeated.

In the example shown in Fig. 6, the user again evaluates the footwear 10 designed based on the standard fit criterion S1a as a relative value with respect to the desired preferred fit (level selected by the user), not in the five levels: loose, slightly loose, average, slightly tight, and tight. Specifically, in the example shown in Fig. 6, the user wearing the footwear 10 designed based on the standard fit criterion S1a is asked the question "What did you think of actual fitting compared to your preference?" to cause the user to evaluate the footwear 10 as the relative value with respect to the desired preferred fit. As the relative value for the evaluation of the fit, the design assistance apparatus 1 receives the answer "Slightly looser than my preference" from the user, for example.

That is, in the example shown in Fig. 6, the evaluation value for the fit evaluated by the user is indicated by five levels: looser than preference, slightly looser than preference, suited to preference, slightly tighter than preference, and tighter than preference, as a relative value Fb with respect to the level selected by the user ("slightly tight" in Fig. 6). The design assistance apparatus 1 receives the evaluation value for the fit evaluated by the user as relative value Fb, whereby the design assistance apparatus 1 can understand relative value Fb as an amount of deviation from the desired preferred fit (level selected by the user). Specifically, the amount of deviation (relative value Fb) from the desired preferred fit is set to -10% with respect to the reference design value in the case of looser than preference, -5% with respect to the reference design value in the case of slightly looser than preference, +0% with respect to the reference design value in the case of suited to preference, +5% with respect to the reference design value in the case of slightly tighter than preference, and +10% with respect to the reference design value in the case of tighter than preference. The numerical values in relative value Fb for the evaluation of the fit in the present disclosure are provided by way of example and are not intended to be limiting.

When the user evaluation value is "Slightly looser than my preference", the design assistance apparatus 1 shifts the design value for each level in the standard fit criterion S1a by -5%, thereby obtaining the criterion that matches the user's recognition. Therefore, the design assistance apparatus 1 determines a user fit criterion S2b as a conversion criterion (-5% with respect to the reference design value) for converting the standard fit criterion S1a. That is, the design assistance apparatus 1 does not determine the user fit criterion S2a separately from the standard fit criterion S1a, but determines the user fit criterion S2b as the conversion criterion for converting the standard fit criterion S1a. The design assistance apparatus 1 outputs the determined user fit criterion S2b to the storage 13 and stores the determined user fit criterion S2b. The design assistance apparatus 1 may output the determined user fit criterion S2b to another device such as a server.

When the design assistance apparatus 1 designs a new footwear 10 having a fit desired by the user, the design assistance apparatus 1 designs the footwear 10 using the user fit criterion S2b as the conversion criterion for converting the standard fit criterion S1a. Specifically, when the design assistance apparatus 1 newly produces the footwear 10, the design assistance apparatus 1 receives the user's preferred fit based on the user's answer "I like tight" to the question "What kind of fit do you like?". The design assistance apparatus 1 applies the user fit criterion S2b to the standard fit criterion S1a stored in the storage 13, and modifies, with 90% - 5% = 85% of the reference design value, the design data about the footwear 10 generated based on the foot shape data. As a result, the design assistance apparatus 1 can design, based on the user fit criterion S2b, the footwear 10 having the properties that satisfy the user.

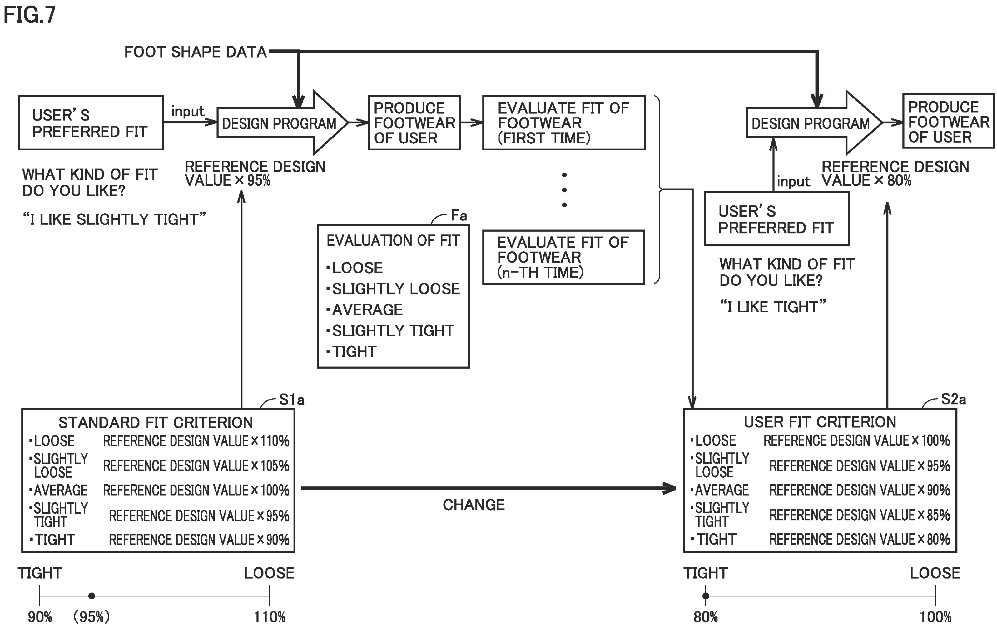

Furthermore, in Fig. 5, the user fit criterion S2a is determined based on a one-time fit evaluation by the user performed on the footwear 10 designed based on the standard fit criterion S1a. However, the fit criterion S2a may be determined based on fit evaluations performed multiple times. Fig. 7 is still another schematic diagram showing the design process and the feedback process in the design assistance apparatus 1 according to the embodiment. In the schematic diagram shown in Fig. 7, the same components as those in the schematic diagram shown in Fig. 5 are denoted by the same reference characters and detailed description will not be repeated.

In the example shown in Fig. 7, the user evaluates the fit of the footwear 10 designed based on the standard fit criterion S1a, for example, n times (n is a natural number) during different time periods. The design assistance apparatus 1 performs statistical processing on an average value or the like of the results of evaluations of the fit performed n times, thereby determining the fit criterion S2a. Specifically, the user wearing the footwear 10 performs a first-time evaluation of the fit in the first week, and performs an n-th evaluation of the fit one year later. The design assistance apparatus 1 averages the ratios of the reference design values based on the first to n-th evaluations of the fit, thereby determining the user fit criterion S2a. As a result, the design assistance apparatus 1 can determine the user fit criterion S2a including a change of the footwear 10 over time, and can design the footwear 10 having the fit that satisfies the user for a long time.

### [Modification of User Criterion]

In the above-described design assistance apparatus 1, the feedback process for providing the feedback about the subjective evaluation by the user, thereby determining the user criterion S2 that matches the user's subjective opinion is performed. In this feedback process, the user criterion S2 is determined by equally shifting the design values for the respective levels in the standard criterion S1 based on the difference between the level determined in the standard criterion S1 and the level evaluated by the user.

However, when consideration is given to use information such as how long the user uses the footwear 10 or how many times the user uses the footwear 10, and user information such as the height and weight of the user and a running score, the footwear 10 having the properties that satisfy the user can be designed by setting the design values in accordance with the respective levels, rather than by equally shifting the design values for the respective levels. Thus, the design assistance apparatus 1 may modify the design values for the respective levels in the user criterion S2 based on the use information and the user information.

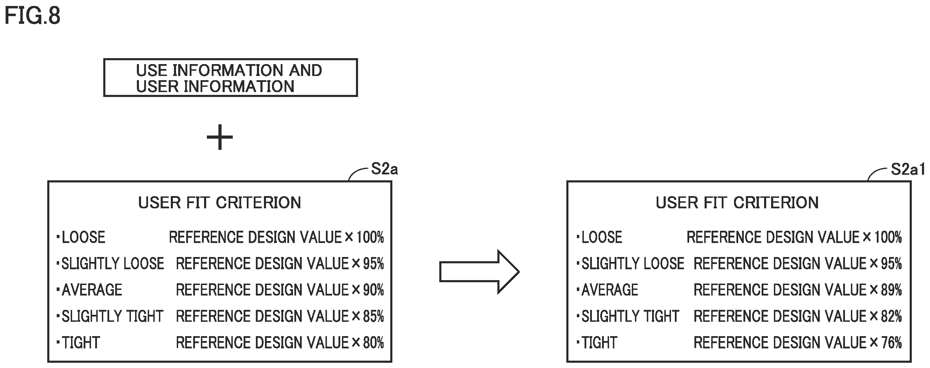

Fig. 8 is a schematic diagram showing modification of the user criterion based on the use information and the user information. For example, when a period of use longer than a standard period of use is included as the use information, it is preferable to slightly decrease the design values for tight and slightly tight such that the fit of the footwear 10 can be maintained for the long period of use. When the design assistance apparatus 1 receives the period of use longer than the standard period of use as the use information, the design assistance apparatus 1 modifies the user fit criterion S2a determined in step S107 to user fit criterion S2a1 in which the design value for tight is 76% of the reference design value, the design value for slightly tight is 82% of the reference design value, and the design value for average is 89% of the reference design value, as shown in Fig. 8.

Further, for example, when a running score higher than a standard score is included as the user information, it is preferable to slightly decrease the design values for loose and slightly loose in consideration of the running performance of the footwear 10, even when the user preference is loose or slightly loose. The values shown in Fig. 8 are provided by way of example and are not intended to be limiting.

Next, the design assistance apparatus 1 can provide a feedback about subjective evaluation by the user, thereby determining the user criterion S2 that matches the user's subjective opinion. However, the design values cannot be changed to such an extent that the footwear 10 does not work anymore. For example, even when the user preference is tight, there is a safety issue in decreasing the design values to such an extent that blood circulation in the foot is restricted. Conversely, even when the user preference is loose, there is a safety issue in increasing the design values to such an extent that stable running becomes impossible. Thus, the design assistance apparatus 1 may modify the design values for the respective levels in the user criterion S2 based on a safety criterion. The safety criterion may include a manufacturing limit of the apparatus such as the 3D printer 3.

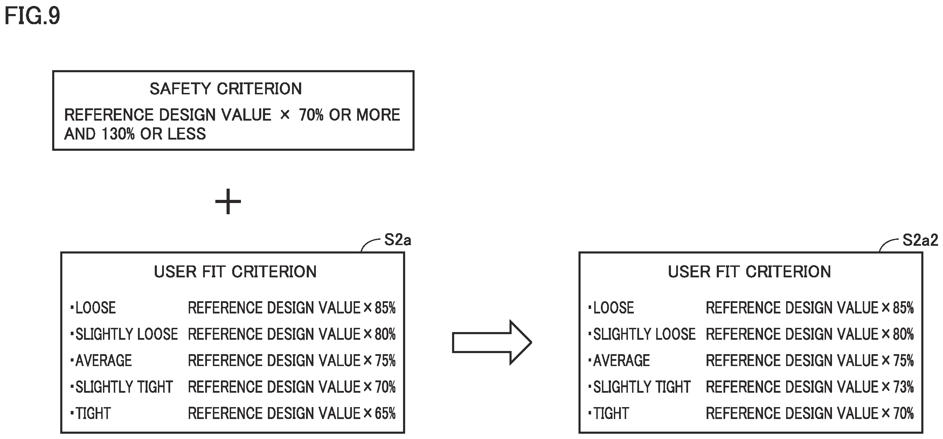

Fig. 9 is a schematic diagram showing modification of the user criterion based on the safety criterion. For example, when the user preference is tight and the design values are extremely decreased, it is preferable to increase the design values for tight and slightly tight to fall within the range of the safety criterion (e.g., 70% or more and 130% or less of the reference design value). The design assistance apparatus 1 modifies the user fit criterion S2a shown in Fig. 9 to a user fit criterion S2a2 in which the design value for tight is 70% of the reference design value and the design value for slightly tight is 73% of the reference design value. The values shown in Fig. 9 are provided by way of example and are not intended to be limiting.

Next, the design values of the footwear 10 may be changed to be tighter, or may be changed to be looser, in accordance with a purpose of use. For example, the design values of the footwear 10 for soccer may be changed to be tighter than the design values of the footwear 10 for running. Thus, the design assistance apparatus 1 may modify the design values for the respective levels in user criterion S2 in accordance with the purpose of use of the footwear 10.

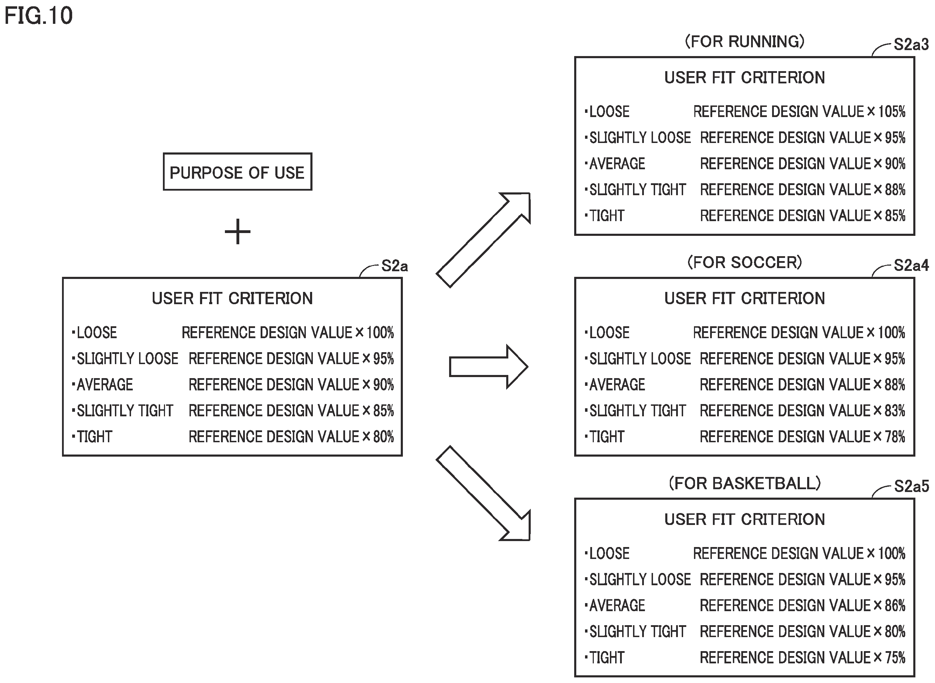

Fig. 10 is a schematic diagram showing the user criterion generated in accordance with the purposes of use. For example, it is preferable that the design values of the footwear 10 for soccer should be tighter than the design values of the footwear 10 for running, and it is preferable that the design values of the footwear 10 for basketball should be tighter than the design values of the footwear 10 for soccer. Based on the information about the purpose of use, the design assistance apparatus 1 modifies the user fit criterion S2a shown in Fig. 10 to a user fit criterion for running S2a3 (e.g., the design value for tight is 85% of the reference design value), a user fit criterion for soccer S2a4 (e.g., the design value for tight is 78% of the reference design value), and a user fit criterion for basketball S2a5 (e.g., the design value for tight is 75% of the reference design value). The values shown in Fig. 10 are provided by way of example and are not intended to be limiting.

### [User Criterion for Each Portion of Footwear]

In the above-described design assistance apparatus 1, the feedback process for providing the feedback about the subjective evaluation of the footwear by the user, thereby determining the user criterion S2 for the footwear that matches the user's subjective opinion is performed. However, the user criterion S2 for the footwear is not one for the entire footwear, and different user criteria S2 may be determined for respective portions of the footwear. For example, regarding the fit of the footwear, the footwear having the more preferred fit can be designed by determining the user criteria S2 for a forefoot portion, a midfoot portion and a rearfoot portion, rather than by determining the user criterion S2 for the entire foot.

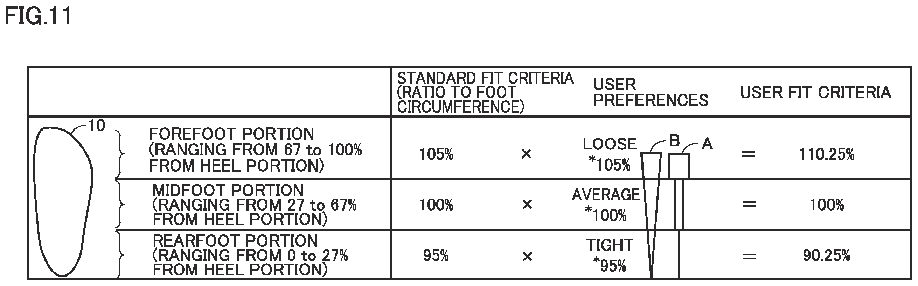

Fig. 11 is a schematic diagram showing the user criteria for the respective portions of the footwear. Fig. 11 shows the user fit criteria for the forefoot portion, the midfoot portion and the rearfoot portion of the footwear 10. Assuming that a heel portion of the footwear 10 is 0% and a toe portion of the footwear 10 is 100%, the forefoot portion is a portion ranging from 67% to 100% from the heel portion, the midfoot portion is a portion ranging from 27% to 67% from the heel portion, and the rearfoot portion is a portion ranging from 0% to 27% from the heel portion. The standard fit criteria (here, ratios to the foot circumference) for the respective portions are 105% for the forefoot portion, 100% for the midfoot portion, and 95% for the rearfoot portion. When the user preferences for the footwear 10 produced based on the standard fit criteria are loose (105%) for the forefoot portion, average (100%) for the midfoot portion, and tight (95%) for the rearfoot portion, the standard fit criteria are multiplied by the user preferences for the respective portions, thereby determining the user fit criteria. Specifically, in Fig. 11, the user fit criteria are 110.25% for the forefoot portion, 100% for the midfoot portion, and 90.25% for the rearfoot portion. The numerical values indicating the ranges of the forefoot portion, the midfoot portion and the rearfoot portion of the footwear 10 and the numerical values in the fit criteria shown in Fig. 11 are provided by way of example and are not intended to be limiting.

As described above, by determining the user fit criteria for the respective portions of the footwear 10, the footwear having the more preferred fit can be designed. The user fit criteria for the respective portions of the footwear 10 are not limited to a configuration in which the values change in a stepwise manner in order of the forefoot portion, the midfoot portion and the rearfoot portion as shown by a representation A, but may be a configuration in which the values change continuously from the forefoot portion to the rearfoot portion as shown by a representation B.

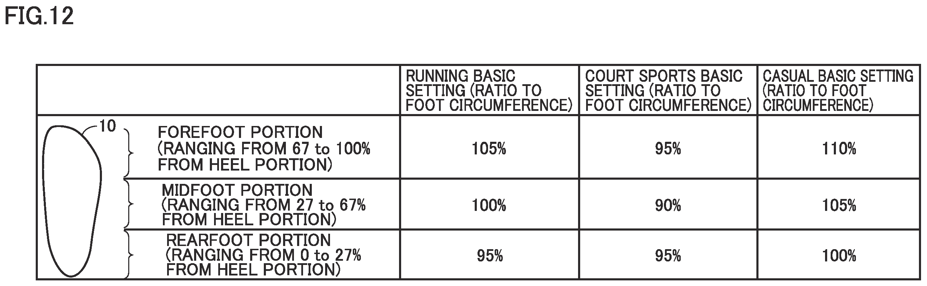

Furthermore, the user fit criteria for the respective portions of the footwear 10 may be changed in accordance with the purpose of use. Fig. 12 is a schematic diagram showing the user criteria for the respective portions of the footwear generated in accordance with the purpose of use. Fig. 12 shows the ratios to the foot circumference for the respective portions of the footwear 10 in a running basic setting for running, a court sports basic setting for court sports such as tennis, and a casual basic setting for daily use.

Specifically, in the running basic setting, the ratios are 105% for the forefoot portion, 100% for the midfoot portion, and 95% for the rearfoot portion. In the court sports basic setting, the ratios are 95% for the forefoot portion, 90% for the midfoot portion, and 95% for the rearfoot portion. In the casual basic setting, the ratios are 110% for the forefoot portion, 105% for the midfoot portion, and 100% for the rearfoot portion. These basic settings may be multiplied by the user preferences described with reference to Fig. 11, thereby determining the user fit criteria for each purpose of use. The numerical values indicating the ranges of the forefoot portion, the midfoot portion and the rearfoot portion of the footwear 10 and the numerical values in the fit criteria shown in Fig. 12 are provided by way of example and are not intended to be limiting.

### [Other Modifications]

The present disclosure is not limited to the examples above, but can variously be modified and applied. Modifications applicable to the present disclosure will be described below.

In the design assistance apparatus 1 according to the embodiment, the feedback about the subjective evaluation by the user is provided and the user criterion S2 that matches the user's subjective opinion is temporarily determined, and then, the design values for the respective levels in the user criterion S2 are modified based on the information such as the use information, the safety criterion and the purpose of use. However, the present disclosure is not limited thereto. The design assistance apparatus 1 may receive the feedback about the subjective evaluation by the user and the information such as the use information, the safety criterion and the purpose of use at the same time and determine the user criterion S2.

The design assistance apparatus 1 may be disposed in a store equipped with the measuring apparatus 2, or may be a server device on the cloud. Furthermore, the design assistance apparatus 1, if it is a server device on the cloud, may be communicatively connected to the measuring apparatus 2 disposed in each of a plurality of stores and generate design data of the footwear 10 based on foot shape data obtained from each of the measuring apparatuses 2.

Although the design assistance apparatus 1 has been described based on the premise that the design assistance apparatus 1 produces the custom-made footwear 10, the design assistance apparatus 1 may be applied to a commercially-available footwear. The design assistance apparatus 1 may recommend a user's preferred commercially-available footwear based on a standard criterion and provide a feedback about evaluation by the user actually wearing the footwear, thereby determining a user criterion. The design assistance apparatus 1 recommends the user's preferred commercially-available footwear based on the determined user criterion. Therefore, the design assistance apparatus 1 can provide, to the user, the footwear more suited to the user preference.

### [Aspects]

(1) A design assistance apparatus according to the present disclosure is a design assistance apparatus for designing a product suited to a preference of a user, the design assistance apparatus comprising:
   a storage unit that stores in advance a first criterion that allows selection from a plurality of levels of a property of the product;
   an input unit that receives an evaluation value obtained based on evaluation by the user after the user uses the product manufactured in accordance with a level selected by the user from the first criterion;
   processing circuitry that determines, based on the evaluation value and the first criterion, a second criterion for the property of the product that matches the evaluation by the user; and
   an output unit that outputs the second criterion determined by the processing circuitry.
   With such a configuration, the design assistance apparatus determines the second criterion for the property of the product that matches the evaluation by the user, whereby the design assistance apparatus can design, based on the evaluation by the user, the product having the property that satisfies the user.
(2) In the design assistance apparatus according to (1),
   the evaluation value received by the input unit is a value based on the plurality of levels of the property of the product, and
   the processing circuitry determines the second criterion such that the level in the evaluation value matches the level in the first criterion.
   With such a configuration, the design assistance apparatus can determine the second criterion for the property of the product that matches the evaluation by the user, which is different from the first criterion.
(3) In the design assistance apparatus according to (1),
   the evaluation value received by the input unit is a relative value with respect to the level selected by the user, and
   the processing circuitry determines the second criterion as a conversion criterion for converting the first criterion to correspond to the relative value serving as the evaluation value.
   With such a configuration, the design assistance apparatus can determine, using the first criterion, the second criterion for the property of the product that matches the evaluation by the user.
(4) In the design assistance apparatus according to any one of (1) to (3),
   when the input unit newly receives the evaluation value, the processing circuitry updates the second criterion based on the newly received evaluation value.
   With such a configuration, the design assistance apparatus can determine the second criterion for the property of the product that matches the latest evaluation by the user.
(5) In the design assistance apparatus according to any one of (1) to (4),
   the input unit further receives use information about use of the product, and
   the processing circuitry modifies the second criterion based on the use information.
   With such a configuration, the design assistance apparatus can determine the second criterion in consideration of the use information.
(6) In the design assistance apparatus according to any one of (1) to (5),
   the input unit further receives user information about the user, and
   the processing circuitry modifies the second criterion based on the user information.
   With such a configuration, the design assistance apparatus can determine the second criterion in consideration of the user information.
(7) In the design assistance apparatus according to any one of (1) to (6),
   the input unit further receives purpose-of-use information about a purpose of use of the product by the user, and
   the processing circuitry determines the second criterion for each piece of the purpose-of-use information.
   With such a configuration, the design assistance apparatus can determine the second criterion in consideration of the purpose of use.
(8) In the design assistance apparatus according to any one of (1) to (7),
   the storage unit stores in advance a safety criterion for safely using the product, and
   the processing circuitry modifies the second criterion based on the safety criterion.
   With such a configuration, the design assistance apparatus can determine the second criterion in consideration of the safety criterion.
(9) In the design assistance apparatus according to any one of (1) to (8),
   the product is a wearable article worn by the user.
   With such a configuration, the design assistance apparatus determines the second criterion for the property that matches the evaluation by the user for the wearable article worn by the user, whereby the design assistance apparatus can design, based on the evaluation by the user, the wearable article having the property that satisfies the user.
(10) A design assistance method according to the present disclosure is a design assistance method for designing a product suited to a preference of a user, the design assistance method comprising:
   reading, from a storage unit, a first criterion that allows selection from a plurality of levels of a property of the product;
   receiving an evaluation value obtained based on evaluation by the user after the user uses the product manufactured in accordance with a level selected by the user from the first criterion;
   determining, based on the evaluation value and the first criterion, a second criterion for the property of the product that matches the evaluation by the user; and
   outputting the determined second criterion.
   With such a configuration, the design assistance method determines the second criterion for the property of the product that matches the evaluation by the user, whereby the design assistance method can design, based on the evaluation by the user, the product having the property that satisfies the user.
(11) A design assistance program according to the present disclosure is a design assistance program performed by a computer for designing a product suited to a preference of a user, the design assistance program causing the computer to implement:
   a reading unit that reads, from a storage unit, a first criterion that allows selection from a plurality of levels of a property of the product;
   an input unit that receives an evaluation value obtained based on evaluation by the user after the user uses the product manufactured in accordance with a level selected by the user from the first criterion;
   processing circuitry that determines, based on the evaluation value and the first criterion, a second criterion for the property of the product that matches the evaluation by the user; and
   an output unit that outputs the determined second criterion.

With such a configuration, the design assistance program determines the second criterion for the property of the product that matches the evaluation by the user, whereby the design assistance program can design, based on the evaluation by the user, the product having the property that satisfies the user.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

### REFERENCE SIGNS LIST

1 design assistance apparatus; 2 measuring apparatus; 3 3D printer; 10 footwear; 11 processor; 12 memory; 13 storage; 14 interface; 15 media reader; 16 communication device; 17 processor bus; 18 removable disk; 21 top plate; 22 laser measuring unit; 130 design program; 131 feedback program; 132 OS.

## Claims

1. A design assistance apparatus for designing a product suited to a preference of a user, the design assistance apparatus comprising:
a storage unit that stores in advance a first criterion that allows selection from a plurality of levels of a property of the product;
an input unit that receives an evaluation value obtained based on evaluation by the user after the user uses the product manufactured in accordance with a level selected by the user from the first criterion;
processing circuitry that determines, based on the evaluation value and the first criterion, a second criterion for the property of the product that matches the evaluation by the user; and
an output unit that outputs the second criterion determined by the processing circuitry.

2. The design assistance apparatus according to claim 1, wherein
the evaluation value received by the input unit is a value based on the plurality of levels of the property of the product, and
the processing circuitry determines the second criterion such that the level in the evaluation value matches the level in the first criterion.

3. The design assistance apparatus according to claim 1, wherein
the evaluation value received by the input unit is a relative value with respect to the level selected by the user, and
the processing circuitry determines the second criterion as a conversion criterion for converting the first criterion to correspond to the relative value serving as the evaluation value.

4. The design assistance apparatus according to any one of claims 1 to 3, wherein
when the input unit newly receives the evaluation value, the processing circuitry updates the second criterion based on the newly received evaluation value.

5. The design assistance apparatus according to any one of claims 1 to 3, wherein
the input unit further receives use information about use of the product, and
the processing circuitry modifies the second criterion based on the use information.

6. The design assistance apparatus according to any one of claims 1 to 3, wherein
the input unit further receives user information about the user, and
the processing circuitry modifies the second criterion based on the user information.

7. The design assistance apparatus according to any one of claims 1 to 3, wherein
the input unit further receives purpose-of-use information about a purpose of use of the product by the user, and
the processing circuitry determines the second criterion for each piece of the purpose-of-use information.

8. The design assistance apparatus according to any one of claims 1 to 3, wherein
the storage unit stores in advance a safety criterion for safely using the product, and
the processing circuitry modifies the second criterion based on the safety criterion.

9. The design assistance apparatus according to any one of claims 1 to 3, wherein
the product is a wearable article worn by the user.

10. A design assistance method for designing a product suited to a preference of a user, the design assistance method comprising:
reading, from a storage unit, a first criterion that allows selection from a plurality of levels of a property of the product;
receiving an evaluation value obtained based on evaluation by the user after the user uses the product manufactured in accordance with a level selected by the user from the first criterion;
determining, based on the evaluation value and the first criterion, a second criterion for the property of the product that matches the evaluation by the user; and
outputting the determined second criterion.

11. A design assistance program performed by a computer for designing a product suited to a preference of a user, the design assistance program causing the computer to implement:
a reading unit that reads, from a storage unit, a first criterion that allows selection from a plurality of levels of a property of the product;
an input unit that receives an evaluation value obtained based on evaluation by the user after the user uses the product manufactured in accordance with a level selected by the user from the first criterion;
processing circuitry that determines, based on the evaluation value and the first criterion, a second criterion for the property of the product that matches the evaluation by the user; and
an output unit that outputs the determined second criterion.
